# EUROPÄISCHE PATENTANMELDUNG

(11) **EP 1 909 534 A2**
(43) Veröffentlichungstag der Anmeldung: **09.04.2008**
(21) Anmeldenummer: 07114054.5
(22) Anmeldetag: 09.08.2007
(51) Int. Cl.: H04R 25/00

(54) **Hörvorrichtung mit unsymmetrischer Klangwaage und entsprechendes Einstellverfahren**

(30) Priorität: 02.10.2006 DE 102006046699
(71) Anmelder: Siemens Audiologische Technik GmbH, 91058 Erlangen (DE)
(72) Erfinder: Barthel, Roland, 91058, Erlangen (DE); Bäuml, Robert, 90542, Eckental (DE); Fischer, Eghart, 91126, Schwabach (DE)
(74) Vertreter: Maier, Daniel Oliver

(57) **Zusammenfassung**

Für Hörvorrichtungen und insbesondere für Hörgeräte soll auch bei schwierigen Randbedingungen eine Klangwaage genutzt werden können. Daher ist eine Hörvorrichtung mit einer Signalverarbeitungseinrichtung, durch die Signale in mehreren Frequenzkanälen (f1, f2, f3, f4) verarbeitbar sind, und einer Einstelleinrichtung zum Einstellen der Pegel der einzelnen Frequenzkanäle vorgesehen. Die Einstelleinrichtung weist eine bezogen auf eine vorgegebene Frequenz unsymmetrische Klangwaage auf, mit der mindestens ein bezogen auf die vorgegebene Frequenz unterer und mindestens ein oberer der mehreren Frequenzkanäle unsymmetrisch zur vorgegebenen Frequenz gleichzeitig verstellbar sind. So kann beispielsweise auch eine Klangwaage bei niedriger Rückkopplungsgrenze (r4') im oberen Frequenzbereich (f4) genutzt werden.

## Beschreibung

Die vorliegende Erfindung betrifft eine Hörvorrichtung mit einer Signalverarbeitungseinrichtung, durch die Signale in mehreren Frequenzkanälen verarbeitbar sind, und einer Einstelleinrichtung zum Einstellen der Pegel der einzelnen Frequenzkanäle. Darüber hinaus betrifft die vorliegende Erfindung ein entsprechendes Verfahren zum Einstellen einer Hörvorrichtung. Unter einer Hörvorrichtung wird im vorliegenden Dokument jedes tragbare und nicht tragbare Gerät zur Erzeugung eines Hörschalls verstanden. Insbesondere fällt unter den Begriff jedoch ein Hörgerät, ein Headset oder ein Kopfhörer.

Hörgeräte sind tragbare Hörvorrichtungen, die zur Versorgung von Schwerhörenden dienen. Um den zahlreichen individuellen Bedürfnissen entgegenzukommen, werden unterschiedliche Bauformen von Hörgeräten wie Hinter-dem-Ohr-Hörgeräte (HdO), Indem-Ohr-Hörgeräte (IdO) und Concha-Hörgeräte bereitgestellt. Die beispielhaft aufgeführten Hörgeräte werden am Außenohr oder im Gehörgang getragen. Darüber hinaus stehen auf dem Markt aber auch Knochenleitungshörhilfen, implantierbare oder vibrotaktile Hörhilfen zur Verfügung. Dabei erfolgt die Stimulation des geschädigten Gehörs entweder mechanisch oder elektrisch.

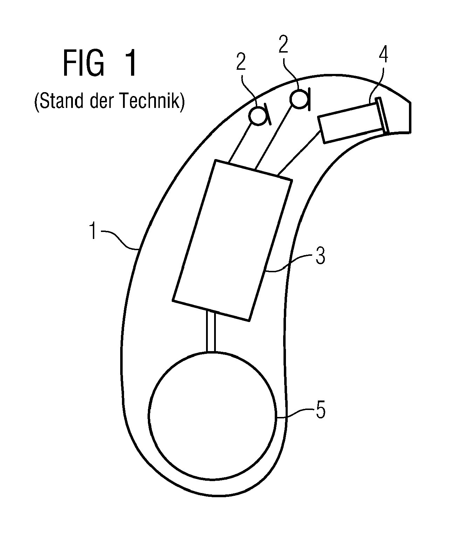

Hörgeräte besitzen prinzipiell als wesentliche Komponenten einen Eingangswandler, einen Verstärker und einen Ausgangswandler. Der Eingangswandler ist in der Regel ein Schallempfänger, z. B. ein Mikrofon, und/oder ein elektromagnetischer Empfänger, z. B. eine Induktionsspule. Der Ausgangswandler ist meist als elektroakustischer Wandler, z. B. Miniaturlautsprecher, oder als elektromechanischer Wandler, z. B. Knochenleitungshörer, realisiert. Der Verstärker ist üblicherweise in eine Signalverarbeitungseinheit integriert. Dieser prinzipielle Aufbau ist in FIG 1 am Beispiel eines Hinter-dem-Ohr-Hörgeräts dargestellt. In ein Hörgerätegehäuse 1 zum Tragen hinter dem Ohr sind ein oder mehrere Mikrofone 2 zur Aufnahme des Schalls aus der Umgebung eingebaut. Eine Signalverarbeitungseinheit 3, die ebenfalls in das Hörgerätegehäuse 1 integriert ist, verarbeitet die Mikrofonsignale und verstärkt sie. Das Ausgangssignal der Signalverarbeitungseinheit 3 wird an einen Lautsprecher bzw. Hörer 4 übertragen, der ein akustisches Signal ausgibt. Der Schall wird gegebenenfalls über einen Schallschlauch, der mit einer Otoplastik im Gehörgang fixiert ist, zum Trommelfell des Geräteträgers übertragen. Die Stromversorgung des Hörgeräts und insbesondere die der Signalverarbeitungseinheit 3 erfolgt durch eine ebenfalls ins Hörgerätegehäuse 1 integrierte Batterie 5.

Unterschiedliche Hörwünsche eines Hörgeräteträgers erklären den Wunsch nach einer Klangwaage im Hörgerät. Die naheliegende Implementierung einer Klangwaage besteht darin, dass durch einen Druck auf die entsprechende Taste (beispielsweise "mehr Höhen") die Höhen im gleichen Maß angehoben werden, wie die Tiefen abgesenkt werden. Diese Lösung kann aber einige Probleme hervorrufen. So wird beispielsweise der Lautheitseindruck zu einem überwiegenden Teil von den tiefen Bändern gebildet. Ist die Klangwaage wie soeben beschrieben symmetrisch, scheint das Signal nicht nur heller, sondern auch leiser zu werden, da ja die laut erscheinenden Tiefen abgesenkt werden.

Ein anderes Problem ist die Begrenzung der Höhen zur Vermeidung von Rückkopplungseffekten, die häufiger bei höheren Frequenzen auftreten. Wird der Regelbereich dort eingeschränkt, um Rückkopplungen vorzubeugen, so wird der nutzbare Regelbereich einer symmetrischen Klangwaage eventuell sehr klein.

Bislang gibt es keine Klangwaage in einem Hörgerät. Klangwaagen werden jedoch bei der Anpassung von Hörgeräten eingesetzt, um während der Anpassung den Klang entsprechend zu ändern. Dabei treten ebenfalls die oben geschilderten Probleme auf, die jedoch der Akustiker mit seinem Fachwissen ohne Weiteres meistern kann. Im Falle der Implementierung einer Klangwaage in einem Hörgerät kann dieses Fachwissen nicht vom Nutzer vorausgesetzt werden.

Aus der Druckschrift EP 1 432 282 A2 ist ein Verfahren zur Anpassung eines Hörgeräts an eine momentane akustische Situation bekannt. Anhand einer identifizierten Umgebungssituation werden Parametersätze automatisch eingestellt. Hierbei können die Parameter eines Parametersatzes gleichzeitig und gemeinsam in einer von zwei entgegengesetzten Richtungen verstellt werden. So werden mit einer Klangbalance durch Betätigen von Tasten hochfrequente Signalanteile angehoben und tieffrequente Signalanteile abgesenkt bzw. umgekehrt. Zur Klangbalance wird auf die Publikation von Harvey Dillon mit dem Titel "Hearing Aids" (Boomerang Press, 2001, ISBN 1-58890-052-5), insbesondere dessen Kapitel 11.1.6 mit dem Untertitel "Tonal quality" (Seite 308), verwiesen.

Darüber hinaus zeigt die Patentschrift DE 101 31 964 B4 ein Verfahren zum Betrieb eines digitalen programmierbaren Hörgeräts. Dabei ist eine Übertragungskennlinie einer maximalen Verstärkung des Audiosignals über der Frequenz einstellbar. In den höheren Frequenzen erfolgt gegebenenfalls eine Verstärkungsabsenkung, um einem Rückkopplungspfeifen entgegenzuwirken, das insbesondere bei hohen Frequenzen vermehrt auftritt.

Des Weiteren ist aus der Druckschrift EP 0 917 398 A2 ein Verfahren zur Einstellung audiologischer bzw. akustischer Parameter bekannt. Auch hier sollen die nutzerspezifischen Parameter, wie beispielsweise die Verstärkung in den einzelnen Kanälen am Hörgerät, eingestellt werden können.

In der Druckschrift DE 27 16 336 B1 ist ein Verfahren und ein Hörgerät zur Kompensation von Gehördefekten beschrieben. Es ist erwähnt, dass das Hörgerät mit einer Klangwaage ausgestattet sein kann. Ferner offenbart die Patentschrift DE 31 41 420 C2 ein Hörgerät, bei dem die Tiefenabsenkung erweitert werden soll. Daher wird eine Klangwippe mit vergrößerter Tiefenabsenkung eingesetzt.

Die Aufgabe der vorliegenden Erfindung besteht somit darin, die Vorteile einer Klangwaage in einer Hörvorrichtung und insbesondere in einem Hörgerät zu nutzen.

Erfindungsgemäß wird diese Aufgabe gelöst durch eine Hörvorrichtung mit einer Signalverarbeitungseinrichtung, durch die Signale in mehreren Frequenzkanälen verarbeitbar sind, und eine Einstelleinrichtung zum Einstellen der Pegel der einzelnen Frequenzkanäle, wobei die Einstelleinrichtung eine bezogen auf eine vorgegebene Frequenz unsymmetrische Klangwaage aufweist, mit der mindestens ein bezogen auf die vorgegebene Frequenz unterer und mindestens ein oberer der mehreren Frequenzkanäle unsymmetrisch zur vorgegebenen Frequenz gleichzeitig verstellbar sind.

Darüber hinaus wird erfindungsgemäß bereitgestellt ein Verfahren zum Einstellen einer Hörvorrichtung durch Verarbeiten von Signalen in der Hörvorrichtung in mehreren Frequenzbändern, Einstellen der Pegel der einzelnen Frequenzkanäle, wobei das Einstellen der Pegel entsprechend einer bezogen auf eine vorgegebene Frequenz unsymmetrischen Klangwaage erfolgt, mit der mindestens ein bezogen auf die vorgegebene Frequenz unterer und mindestens ein oberer der mehreren Frequenzkanäle unsymmetrisch zur vorgegebenen Frequenz gleichzeitig verstellbar sind.

In vorteilhafter Weise ist somit eine an physiologische, technische und subjektive Randbedingungen angepasste Klangwaage in einer Hörvorrichtung nutzbar. Damit kann die Klangwaage auch Nutzern zur Verfügung gestellt werden, bei denen der Einstellbereich mit der symmetrischen Klangwaage zu gering wäre.

In einer speziellen Ausführungsform werden durch die Klangwaage die untersten oder der unterste Frequenzkanal im Pegel nicht verändert, wenn der oberste Frequenzkanal in seinem Pegel verändert wird. Mit dieser speziellen Klangwaage kann erreicht werden, dass sich bei deren Verstellung der Lautheitseindruck kaum verändert.

Vorzugsweise ist der maximale Verstellbereich der Klangwaage in einem Frequenzkanal durch eine Rückkopplungsgrenze beschränkt. Hierdurch können von vorne herein Rückkopplungsartefakte vermieden werden, die sich durch zu hohe Verstärkung in bestimmten Frequenzbereichen ergeben.

Die vorliegende Erfindung ist anhand der beiliegenden Zeichnungen näher erläutert, in denen zeigen:
- FIG 1: eine Darstellung der grundlegenden Signalverarbeitungskomponenten eines Hinter-dem-Ohr-Hörgeräts;
- FIG 2: eine Darstellung der Regelbereiche verschiedener Frequenzkanäle;
- FIG 3: eine Darstellung einer symmetrischen Klangwaage;
- FIG 4: eine unsymmetrische Klangwaage gemäß einer ersten Ausführungsform; und
- FIG 5: eine unsymmetrische Klangwaage gemäß einer zweiten Ausführungsform.

Die nachfolgend näher geschilderten Ausführungsbeispiele stellen bevorzugt Ausführungsformen der vorliegenden Erfindung dar.

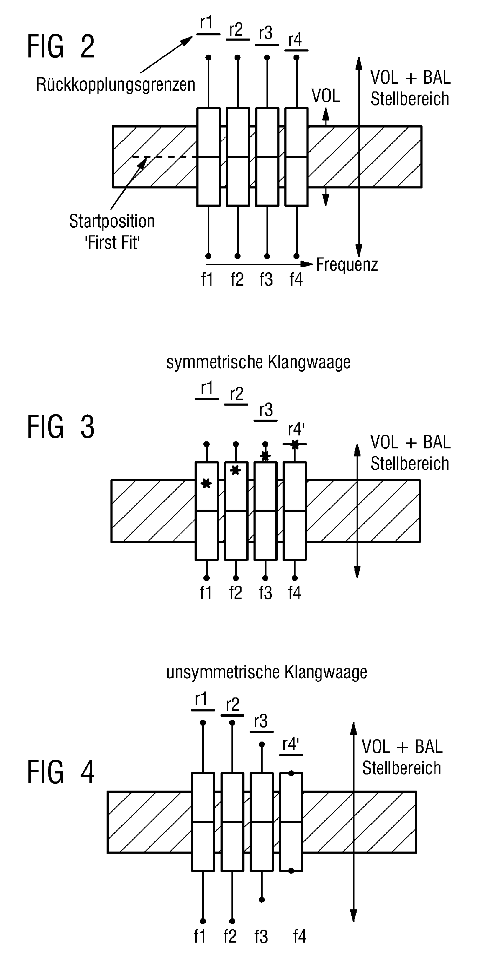

In FIG 2 sind vier Frequenzkanäle f1, f2, f3 und f4 für eine Signalverarbeitungseinheit eines Hörgeräts symbolisch dargestellt. Der Frequenzkanal f1 ist derjenige mit den tiefsten Frequenzen und der Frequenzkanal f4 derjenige mit den höchsten Frequenzen. Die Frequenzbänder f2 und f3 liegen entsprechend dazwischen. Der maximale Lautstärkestellerbereich VOL ist für jeden Frequenzkanal mit einem rechteckigen Kästchen gekennzeichnet. In der Mitte der Lautstärkestellerbereiche ist eine Startposition eingezeichnet, die sich bei einem sogenannten "First Fit" ergibt. Diese Startposition stellt eine mittlere Lautstärke dar, die für einen individuellen Hörgeräteträger bei einer ersten Anpassung ermittelt werden konnte. Von dieser mittleren Lautstärke oder Startposition aus kann der Hörgeräteträger die Lautstärke mit dem Lautstärkesteller nach unten oder oben in dem Maximalbereich VOL regeln.

Mit einem Balancesteller kann die Lautstärke in einem Kanal unabhängig von der Einstellung des Lautstärkesteller ebenfalls verändert werden. Bei einer maximalen Einstellung des Lautstärkestellers an die Obergrenze des Lautstärkestellerbereichs VOL kann also die Lautstärke durch den Balancesteller weiter erhöht werden, wie dies die vertikalen Striche oberhalb der Kästchen jedes Frequenzkanals andeuten. In gleicher Weise lässt sich die Lautstärke durch die Balancesteller weiter reduzieren, wenn die Lautstärkesteller auf die leiseste Einstellung gebracht wurden. Dies deuten die vertikalen Striche unterhalb der Kästchen in FIG 2 an. Insgesamt ergibt sich somit durch die Lautstärkesteller und die Balancesteller ein Gesamtstellbereich VOL + BAL.

In FIG 2 ist darüber hinaus für jeden Frequenzkanal f1 bis f4 jeweils eine Rückkopplungsgrenze r1, r2, r3 und r4 eingezeichnet. Solange die Lautstärkeeinstellung durch Lautstärkesteller und Balancesteller unterhalb der jeweiligen Rückkopplungsgrenze r1 bis r4 bleibt, wird der Hörgeräteträger bzw. Nutzer keine oder kaum eine Rückkopplung wahrnehmen können.

FIG 3 zeigt nun eine symmetrische Klangwaage, die jedoch hier nicht beansprucht wird. Gegenüber dem Beispiel von FIG 2 ist hier der Abstand zwischen der empfohlenen Einstellung (First Fit) und der Rückkopplungsgrenze r4' im obersten Kanal f4 sehr gering. Vorausgesetzt, dass der maximale Lautstärkestellerbereich VOL gleich bleibt, muss der maximale Balancestellerbereich reduziert werden, damit im obersten Frequenzkanal die Rückkopplungsgrenze r4' durch den Gesamtstellbereich VOL + BAL nicht überschritten wird.

In FIG 3 ist ferner durch die vier Sternchen (*) eine Maximaleinstellung einer symmetrischen Klangwaage dargestellt. Bei dieser Einstellung des Balancestellers sind die hohen Frequenzen im gleichen Maße hervorgehoben wie die tiefen Frequenzen gedämpft sind. Die Symmetrie bezieht sich hier auf die Mitte zwischen den Kanälen f2 und f3, gegebenenfalls auf eine fiktive Frequenz, die aber vorgegeben ist. Ausgangsbasis dieser symmetrischen Klangwaage ist die Einstellung des Lautstärkestellers an seine Obergrenze. Es ist zu erkennen, dass nur eine geringfügige Verstellung des Balancestellers aus der Waagrechten genügt, damit die Verstärkung im obersten Frequenzkanal die Rückkopplungsgrenze r4' erreicht. Es ist hier also kaum sinnvoll dem Nutzer eine symmetrische Klangwaage zur Verfügung zu stellen, da der Einstellbereich für die symmetrische Klangwaage zu gering wäre.

In dieser Situation ist es nun hilfreich, eine erfindungsgemäß unsymmetrische Klangwaage zum Beispiel gemäß FIG 4 zur Verfügung zu stellen. Die Unsymmetrie bezieht sich wiederum auf eine vorgegebene Frequenz, z.B. ein mittlerer Frequenzkanal oder die Mitte zweier Frequenzkanäle. Bei dieser unsymmetrischen Klangwaage ändert der Balancesteller eher die Tiefen als die Höhen, so dass zumindest bei den Tiefen (Frequenzkanäle f1, f2) der Regelbereich bzw. Stellbereich sehr groß bleibt. In dem Beispiel von FIG 4 ändert sich die Lautstärkeeinstellung durch den Balancesteller im obersten Frequenzkanal f4 nicht, während sie im zweithöchsten Frequenzkanal f3 geringfügig, aber deutlich weniger als in den unteren Frequenzkanälen f1 und f2 durch den Balancesteller geändert wird. Bei keiner Einstellung des Balancestellers wird jedoch die jeweilige Rückkopplungsgrenze r1, r2, r3, r4' erreicht oder überschritten, obwohl der Nutzer im unteren Frequenzbereich einen großen Balancestellbereich zur Verfügung hat. Es konnte somit eine geeignete Klangwaage für die spezielle Rückkopplungssituation, d.h. die technischen Randbedingungen beim Tragen der Hörvorrichtung, bereitgestellt werden.

Wie im einleitenden Teil der Beschreibung angedeutet ist, verändert sich der Lautheitseindruck insbesondere durch Verändern des Lautstärkepegels bei tiefen Frequenzen. Die symmetrische Klangwaage von FIG 3 ist daher ungeeignet, wenn eine Balanceregelung durchgeführt und dabei der Lautheitseindruck erhalten bleiben soll. So ist aus FIG 3 zu erkennen, dass der Pegel in den tiefen Frequenzkanälen f1 und f2 sinkt, wenn die Höhen in den Kanälen f3 und f4 durch den Balancesteller hochgeregelt werden. Das Ausgangssignal wird daher weniger laut wahrgenommen.

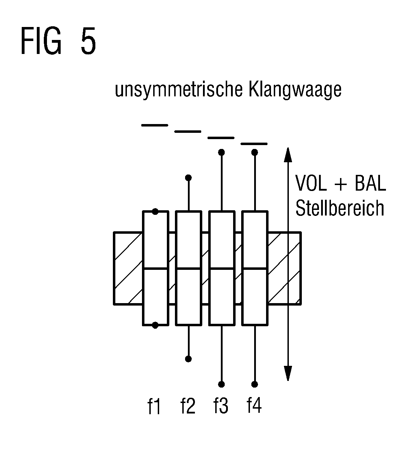

Um starke Schwankungen des Lautheitseindrucks bei Verstellungen des Balancestellers zu vermeiden, wird beispielsweise eine unsymmetrische Klangwaage gemäß FIG 5 genutzt. Bei dieser Klangwaage werden die tiefsten Frequenzen im Kanal f1 durch den Balancesteller nicht beeinflusst und im zweituntersten Kanal nur gering. In den beiden oberen Frequenzkanälen f3 und f4 steht hingegen für den Balancesteller der maximale Stellbereich zur Verfügung. Mit dieser Klangwaage verändert der Nutzer durch den Balancesteller also im Wesentlichen die Höhen, die zwar viel zum Klangeindruck aber weniger zum Lautheitseindruck beitragen. Insbesondere kann so der Lautheitseindruck, den der Akustiker bei der Anpassung fein optimiert hat, festgehalten werden, da sich die Tiefen praktisch nicht ändern.

In den obigen Beispielen wurde die erfindungsgemäße unsymmetrische Klangwaage anhand von vier Frequenzkanälen erläutert. Eine unsymmetrische Klangwaage kann aber auch bei einer beliebigen anderen Anzahl an Frequenzkanälen, beginnend bei zwei, realisiert werden.

Darüber hinaus wurde in den Beispielen gezeigt, dass durch den Balancesteller einmal die hohen Frequenzen und einmal die tiefen Frequenzen nicht verändert werden, während die anderen mehr oder weniger stark verändert werden. Eine unsymmetrische Klangwaage kann jedoch eine beliebige Funktion über der Frequenz darstellen, die ähnlich einer Waage zwei gegenläufig bewegbare Arme besitzt. Extrembeispiele sind die Ausführungsformen von FIG 3 und FIG 5 bei denen einer der beiden Waagenarme die Länge Null besitzt. Wesentlich ist nur, dass die Arme nicht wie bei einer symmetrischen Klangwaage gleich lang sind und auf einer Geraden liegen.

## Patentansprüche

1. Hörvorrichtung mit
- einer Signalverarbeitungseinrichtung (3), durch die Signale in mehreren Frequenzkanälen (f1, f2, f3, f4) verarbeitbar sind, und
- einer Einstelleinrichtung zum Einstellen der Pegel der einzelnen Frequenzkanäle,
**dadurch gekennzeichnet, dass**
- die Einstelleinrichtung eine bezogen auf eine vorgegebene Frequenz unsymmetrische Klangwaage aufweist, mit der mindestens ein bezogen auf die vorgegebene Frequenz unterer (f1) und mindestens ein oberer (f4) der mehreren Frequenzkanäle unsymmetrisch zur vorgegebenen Frequenz gleichzeitig verstellbar sind.

2. Hörvorrichtung nach Anspruch 1, wobei durch die Klangwaage die untersten oder der unterste Frequenzkanal (f1) im Pegel nicht verändert wird, wenn der oberste Frequenzkanal (f4) in seinem Pegel verändert wird.

3. Hörvorrichtung nach Anspruch 1 oder 2, wobei der maximale Verstellbereich (VOL + BAL) der Klangwaage in einem Frequenzkanal durch eine Rückkopplungsgrenze (r1, r2, r3, r4, r4') beschränkt ist.

4. Verfahren zum Einstellen einer Hörvorrichtung durch
- Verarbeiten von Signalen in der Hörvorrichtung in mehreren Frequenzbändern (f1, f2, f3, f4),
- Einstellen der Pegel der einzelnen Frequenzkanäle,
**dadurch gekennzeichnet, dass**
- das Einstellen der Pegel entsprechend einer bezogen auf eine vorgegebene Frequenz unsymmetrischen Klangwaage erfolgt, mit der mindestens ein bezogen auf die vorgegebene Frequenz unterer (f1) und mindestens ein oberer (f4) der mehreren Frequenzkanäle unsymmetrisch zur vorgegebenen Frequenz gleichzeitig verstellbar sind.

5. Verfahren nach Anspruch 4, wobei durch die Klangwaage die untersten oder der unterste Frequenzkanal (f1) im Pegel nicht verändert wird, wenn der oberste Frequenzkanal (f4) in seinem Pegel verändert wird.

6. Verfahren nach Anspruch 4 oder 5, wobei der maximale Verstellbereich (VOL + BAL) der Klangwaage in einem Frequenzkanal durch eine Rückkopplungsgrenze (r1, r2, r3, r4) beschränkt ist.
